# EUROPÄISCHE PATENTSCHRIFT

(11) **EP 0 765 034 B1**
(45) Veröffentlichungstag und Bekanntmachung des Hinweises auf die Patenterteilung: **10.11.2004**
(21) Anmeldenummer: 96113309.7
(22) Anmeldetag: 20.08.1996
(51) Int. Cl.: H03K 17/945

(54) **Elektronisches Schaltgerät**
Electronic switching device
Dispositif électronique de commutation

(30) Priorität: 19.09.1995 DE 19534665
(43) Veröffentlichungstag der Anmeldung: 26.03.1997
(73) Patentinhaber: Endress + Hauser GmbH + Co. KG., 79689 Maulburg (DE)
(72) Erfinder: Dreyer, Volker, 79541 Lörrach (DE); Strütt, Bernd, 79585 Steinen (DE)
(74) Vertreter: Andres, Angelika

(56) Entgegenhaltungen:
- EP-A- 0 092 711
- DE-C- 4 027 386
- GB-A- 2 078 039

## Beschreibung

Die Erfindung betrifft ein elektronisches Schaltgerät zur Steuerung der Verbindung einer Last mit einer Spannungsquelle in Abhängigkeit von einer zu überwachenden physikalischen Größe, mit einem Sensor, der ein von der physikalischen Größe abhängiges Ausgangssignal liefert, einer mit dem Sensor verbundenen Signalverarbeitungsschaltung, die ein binäres Signal liefert, das den einen oder den anderen Signalwert in Abhängigkeit davon annimmt, ob der Wert der zu überwachenden physikalischen Größe über oder unter einem vorgegebenen Schwellenwert liegt, einem Schalter, der die Verbindung zwischen der Spannungsquelle und der Last steuert und durch ein vom Signalwert des Ausgangssignals der Signalverarbeitungsschaltung abhängiges binäres Schaltsignal geöffnet oder geschlossen wird, und mit einem steuerbaren Inverter, der in Abhängigkeit vom Signalwert eines binären Steuersignals das Ausgangssignal der Signalverarbeitungsschaltung entweder direkt für eine erste Betriebsart oder invertiert für eine zweite Betriebsart als Schaltsignal zu dem Schalter überträgt, wobei das Schaltgerät drei Schaltgerätanschlüsse für den Anschluß der Spannungsquelle und der Last hat und so ausgebildet ist, daß es durch unterschiedliches Anschließen der Spannungsquelle und der Last für den Betrieb in der ersten Betriebsart oder für den Betrieb in der zweiten Betriebsart einstellbar ist, und wobei die Spannungsquelle eine Gleichspannungsquelle ist, die auch die für den Betrieb des Schaltgeräts erforderliche Versorgungsspannung zu einem Versorgungsspannungsleiter im Schaltgerät liefert.

Ein aus der DE 31 23 828 C3 bekanntes elektronisches Schaltgerät dieser Art ist ein berührungslos arbeitender Annäherungsschalter. Bei solchen Annäherungsschaltern ist die zu überwachende physikalische Größe eine elektrische oder optische Größe, die durch die Annäherung eines Gegenstandes, Materials oder Lebewesens beeinflußt wird. Grundsätzlich kann jedoch mit einem solchen elektronischen Schaltgerät jede beliebige physikalische Größe überwacht werden, für die es einen Sensor gibt, der die physikalische Größe erfassen und in ein vom Wert der physikalischen abhängiges elektrisches Signal umsetzen kann. Bekannte Beispiele für solche physikalischen Größen sind Druck, Temperatur, Feuchte, Füllstand usw. Das Schaltgerät soll in der Lage sein, wahlweise in der einen oder in der anderen von zwei Betriebsarten zu arbeiten: In der einen Betriebsart soll es die Last mit der Spannungsquelle verbinden, wenn der Wert der zu überwachenden physikalischen Größe einen vorgegebenen Maximalwert überschreitet, und in der anderen Betriebsart soll es die Last mit der Spannungsquelle verbinden, wenn der Wert der zu überwachenden physikalischen Größe einen vorgegebenen Minimalwert unterschreitet. Das Schaltgerät soll ohne konstruktive Änderung und ohne Eingriff in die innere Schaltung lediglich durch unterschiedliche Verbindung der Spannungsquelle und der Last mit den Schaltgerätanschlüssen in die eine oder die andere Betriebsart einstellbar sein.

Bei dem in der DE 31 23 828 C3 beschriebenen Schaltgerät ist die Spannungsquelle zwischen einem ersten und einem zweiten Schaltgerätanschluß angeschlossen, und die Last ist einerseits bleibend mit einem Pol der Spannungsquelle und andrerseits mit dem dritten Schaltgerätanschluß verbunden. Der Steuereingang des steuerbaren Inverters, der durch eine Exklusiv-ODER-Schaltung gebildet ist, ist direkt mit dem zweiten Schaltgerätanschluß verbunden, so daß die an diesem Schaltgerätanschluß anliegende Spannung der Spannungsquelle das binäre Steuersignal bildet, und die Umschaltung zwischen den beiden Betriebsarten erfolgt durch Umpolung der Spannungsquelle zwischen dem ersten und dem zweiten Schaltgerätanschluß. Damit trotz dieser Umpolung die für den Betrieb des Schaltgeräts erforderliche Versorgungsspannung stets die gleiche Polarität hat, wird diese Versorgungsspannung an einer zwischen dem ersten und dem zweiten Schaltgerätanschluß angeschlossenen Gleichrichterbrücke abgenommen. Es ist daher nicht möglich, daß Schaltgerät, Spannungsquelle und Last gleichzeitig auf einem gemeinsamen Bezugspotential, beispielsweise dem Massepotential liegen.

Bei einem aus der DE 32 14 836 C2 bekannten elektronischen Schaltgerät ähnlicher Art, bei dem jedoch die Spannungsquelle eine Wechselspannungsquelle ist, liegt die Last in Reihe mit der Spannungsquelle, und die Einstellung des Schaltgeräts in die eine oder die andere Betriebsart erfolgt dadurch, daß die Reihenschaltung aus Last und Spannungsquelle entweder zwischen dem ersten und dem zweiten Schaltgerätanschluß oder zwischen dem ersten und dem dritten Schaltgerätanschluß angeschlossen ist, während der andere Schaltgerätanschluß jeweils frei bleibt. Die für den Betrieb des Schaltgeräts erforderliche Gleichspannung wird durch eine Gleichrichterbrücke erzeugt, die für jeden Schaltgerätanschluß eine eigene Halbbrücke enthält. Das binäre Steuersignal für den steuerbaren Inverter wird über eine Diode am dritten Schaltgerätanschluß abgegriffen. Die bei diesem Schaltgerät angewendete Reihenschaltung von Last und Spannungsquelle hat gleichfalls zur Folge, daß Schaltgerät, Spannungsquelle und Last nicht alle gleichzeitig auf einem gemeinsamen Bezugspotential, beispielsweise dem Massepotential, liegen können.

Aufgabe der Erfindung ist die Schaffung eines Schaltgeräts der angegebenen Art, das bei einfachem Aufbau durch unterschiedliches Anschließen von Last und Spannungsquelle an die Schaltgerätanschlüsse derart in die eine oder andere Betriebsart einstellbar ist, daß in jeder Betriebsart Schaltgerät, Spannungsquelle und Last auf einem gemeinsamen Bezugspotential liegen können.

Nach der Erfindung wird diese Aufgabe dadurch gelöst, daß ein erster Anschluß der Spannungsquelle und ein erster Anschluß der Last mit einem gemeinsamen ersten Schaltgerätanschluß verbunden sind, daß der zweite und der dritte Schaltgerätanschluß jeweils über eine Diode mit dem Versorgungsspannungsleiter im Schaltgerät verbunden sind, daß die eine Seite des Schalters mit dem Versorgungsspannungsleiter und die andere Seite des Schalters jeweils über eine Diode mit dem zweiten und dem dritten Schaltgerätanschluß verbunden ist, daß das Schaltgerät einen Speicher für eine binäre Information enthält, der an einem ersten Signaleingang das von dem steuerbaren Inverter geliefert Schaltsignal und an einem zweiten Signaleingang ein von der Spannung zwischen dem ersten und dem zweiten Schaltgerätanschluß abhängiges Umsteuersignal empfängt und an seinem Ausgang das binäre Steuersignal für den steuerbaren Inverter liefert, dessen Signalwert von der im Speicher gespeicherten binären Information abhängt, daß der Speicher so ausgebildet ist, daß er eine durch den Wert des Umsteuersignals bestimmte binäre Information speichert, wenn das Schaltsignal den Signalwert hat, bei dem der Schalter geöffnet ist, und die zuvor gespeicherte binäre Information beibehält, wenn das Schaltsignal den Wert hat, bei dem der Schalter geschlossen ist, und daß zur Einstellung einer der beiden Betriebsarten der zweite Anschluß der Spannungsquelle mit dem zweiten Schaltgerätanschluß und der zweite Anschluß der Last mit dem dritten Schaltgerätanschluß verbunden sind und zur Einstellung der anderen Betriebsart diese beiden Verbindungen vertauscht sind.

Bei dem erfindungsgemäßen Schaltgerät sind die Spannungsquelle und die Last jeweils an einem ihrer Anschlüsse bleibend mit einem gemeinsamen Schaltgerätanschluß verbunden, der auf einem festen Bezugspotential liegen kann. Vorzugsweise ist das feste Bezugspotential das Massepotential, was den Vorteil ergibt, daß das Gerät unempfindlicher gegen hochfrequente Störungen ist, da diese über Masse abfließen. Die anderen Anschlüsse von Spannungsquelle und Last sind unabhängig voneinander mit jeweils einem der beiden übrigen Schaltgerätanschlüsse verbunden, und die Einstellung in die eine oder die andere Betriebsart geschieht durch einfaches Vertauschen dieser beiden Verbindungen. Der im Schaltgerät enthaltene Speicher erkennt die Art der Verbindung und speichert eine entsprechende binäre Information, die das zum Inverter gelieferte Steuersignal so einstellt, daß der Inverter in der der Anschlußweise entsprechenden Betriebsart arbeitet.

Wenn die von der Spannungsquelle gelieferte Gleichspannung einen Wert hat, der unmittelbar für das zum Speicher gelieferte Umsteuersignal geeignet ist, kann das Umsteuersignal direkt am zweiten Schaltgerätanschluß abgegriffen werden. Wenn dieser Spannungswert zu groß ist, besteht eine vorteilhafte Ausführungsform der Erfindung darin, daß zwischen dem ersten und dem zweiten Schaltgerätanschluß ein Spannungsteiler angeschlossen ist, an dessen Abgriff das Umsteuersignal abgenommen wird. In diesem Fall ist der Spannungsteiler vorzugsweise durch die Reihenschaltung eines Widerstands und einer Zenerdiode gebildet.

Weitere Merkmale und Vorteile der Erfindung ergeben sich aus der folgenden Beschreibung von Ausführungsbeispielen, die in den Zeichnungen dargestellt sind. In den Zeichnungen zeigen:
- Fig. 1: das Schaltbild einer ersten Ausführungsform eines als Füllstandsgrenzschalter ausgebildeten elektronischen Schaltgeräts gemäß der Erfindung in der Betriebsart für die Überwachung eines maximalen Füllstands,
- Fig. 2: ein vereinfachtes Ersatzschaltbild der ersten Ausführungsform des elektronischen Schaltgeräts in der Betriebsart von Fig. 1,
- Fig. 3: das Schaltbild der ersten Ausführungsform des als Füllstandsgrenzschalter ausgebildeten Schaltgeräts in der Betriebsart für die Überwachung eines minimalen Füllstands,
- Fig. 4: ein vereinfachtes Ersatzschaltbild der ersten Ausführungsform des elektronischen Schaltgeräts in der Betriebsart von Fig. 3,
- Fig. 5: das Schaltbild einer zweiten Ausführungsform des als Füllstandsgrenzschalter ausgebildeten elektronischen Schaltgeräts gemäß der Erfindung in der Betriebsart für die Überwachung eines maximalen Füllstands,
- Fig. 6: ein vereinfachtes Ersatzschaltbild der zweiten Ausführungsform des elektronischen Schaltgeräts in der Betriebsart von Fig. 5,
- Fig. 7: das Schaltbild der zweiten Ausführungsform des als Füllstandsgrenzschalter ausgebildeten Schaltgeräts in der Betriebsart für die Überwachung eines minimalen Füllstands und
- Fig. 8: ein vereinfachtes Ersatzschaltbild der zweiten Ausführungsform des elektronischen Schaltgeräts in der Betriebsart von Fig. 7.

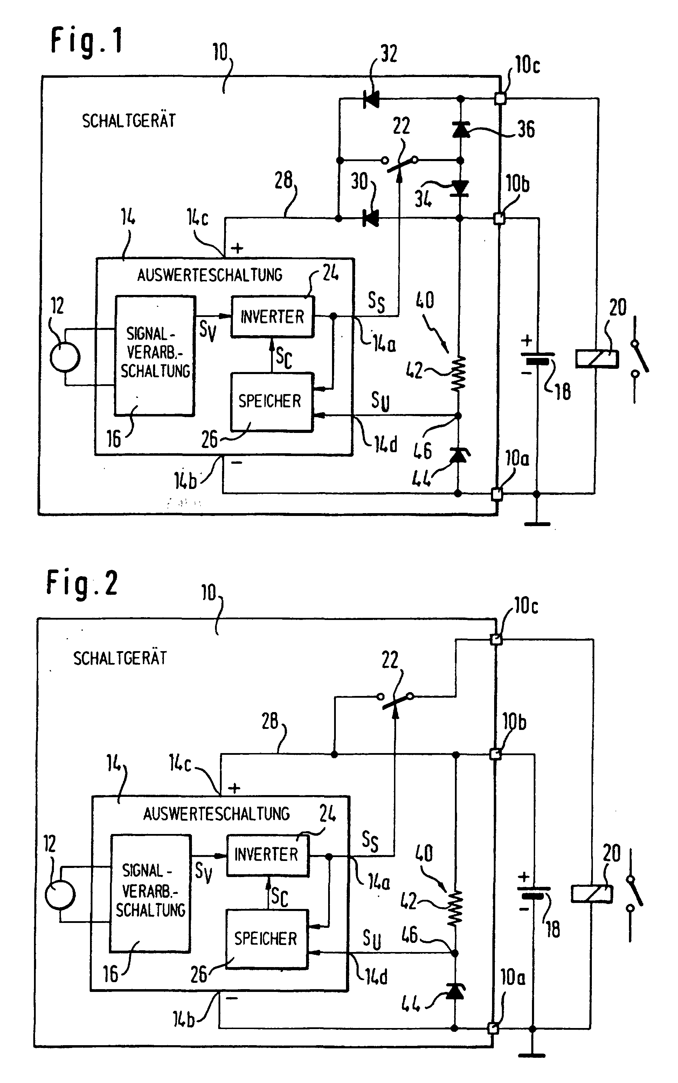

Das in Fig. 1 der Zeichnung dargestellte elektronische Schaltgerät 10 dient zur Auslösung eines Schaltvorgangs in Abhängigkeit von einer zu überwachenden physikalischen Größe. Es enthält zu diesem Zweck einen Sensor 12, der für die zu überwachende physikalische Größe empfindlich ist und ein für die physikalische Größe kennzeichnendes elektrisches Signal liefert, und eine mit dem Sensor 12 verbundene Auswerteschaltung 14, die aufgrund des vom Sensor 12 gelieferten elektrischen Signals ein den Schaltvorgang auslösendes Schaltsignal S_{S} erzeugt, das sie an einem Ausgang 14a abgibt. Die Auswerteschaltung 14 hat ferner zwei Anschlüsse 14b, 14c für die erforderliche Betriebsspannung und einen Eingang 14d für ein Umsteuersignal S_{U}, dessen Zweck später erläutert wird.

Bekannte Beispiele für Schaltgeräte dieser Art sind die sogenannten Annäherungsschalter, deren Sensoren, vorzugsweise berührungslos, auf die körperliche Anwesenheit eines Lebewesens, eines Gegenstandes oder eines Materials in der Umgebung ansprechen. Der Sensor 12 kann jedoch auch für Druck, Temperatur, Feuchte oder jede beliebige andere physikalische Größe empfindlich sein, damit das Schaltgerät einen Schaltvorgang auslöst, wenn die zu überwachende physikalische Größe einen vorbestimmten Wert erreicht. Hierfür ist jeder Sensor geeignet, der ein elektrisches Signal in Abhängigkeit von der zu überwachenden Größe erzeugen oder beeinflussen kann. Es sind zahlreiche solcher Sensoren bekannt, beispielsweise induktive, kapazitive, resistive, piezoelektrische und andere Sensoren.

Zum besseren Verständnis soll in der folgenden Beschreibung angenommen werden, daß das Schaltgerät ein sogenannter Füllstandsgrenzschalter ist, der einen Schaltvorgang in Abhängigkeit davon auslöst, ob ein vorbestimmter Füllstand in einem Behälter über- oder unterschritten wird. Der Sensor 12 ist daher ein Füllstandssensor, der darauf anspricht, ob Füllgut in dem Behälter auf der Höhe des zu überwachenden Füllstands vorhanden ist oder nicht. Es sind verschiedene Füllstandssensoren bekannt, die für diesen Zweck geeignet sind, beispielsweise kapazitive Sensoren, deren Kapazität sich in Abhängigkeit davon ändert, ob sie von dem Füllgut bedeckt sind oder nicht, schwingende Sensoren, bei denen sich die Amplitude oder die Frequenz der Schwingungen in Abhängigkeit davon ändert, ob sie von dem Füllgut bedeckt sind oder nicht, usw. Eine in der Auswerteschaltung 14 enthaltene Signalverarbeitungsschaltung 16, die mit dem Sensor 12 verbunden ist, ist je nach der Art des verwendeten Sensors so ausgebildet, daß sie an ihrem Ausgang ein Signal S_{V} liefert, das einen ersten Wert hat, wenn der Sensor feststellt, daß Füllgut auf der zu überwachenden Höhe vorhanden ist, und das einen zweiten Wert hat, wenn der Sensor 12 feststellt, daß auf der zu überwachenden Höhe kein Füllgut vorhanden ist.

Das Schaltgerät 10 hat drei von außen zugängliche Schaltgerätanschlüsse 10a, 10b und 10c. Diese Schaltgerätanschlüsse dienen einerseits zum Anschluß einer äußeren Spannungsquelle 18, die eine Gleichspannungsquelle ist und die erforderliche Betriebsspannung liefert, und andererseits zum Anschluß einer äußeren Last 20, die in Abhängigkeit von dem Schaltzustand des Schaltgeräts 10 mit Strom von der Spannungsquelle 18 versorgt werden soll oder nicht. Als Beispiel ist in der Zeichnung dargestellt, daß die Last 20 ein Relais ist, das in Abhängigkeit von dem Schaltzustand des Schaltgeräts 10 entweder erregt oder nicht erregt ist. Ein in dem Schaltgerät 10 enthaltener Schalter 22, der durch das vom Ausgang 14a der Auswerteschaltung 14 abgegebene Schaltsignal Sₛ betätigt wird, steuert die Stromzufuhr zur Last 20. Der Schalter 22 ist offen, wenn das Schaltsignal S_{S} den einen Signalwert hat, beispielsweise den Wert 0, und er ist geschlossen, wenn das Schaltsignal S_{S} den anderen Signalwert hat, bei dem gewählten Beispiel also den Wert 1. Der Schalter 22 ist symbolisch als mechanischer Schaltkontakt dargestellt; in Wirklichkeit handelt es sich dabei aber um einen schnellen elektronischen Schalter, beispielsweise einen bipolaren Transistor, einen Feldeffekttransistor oder einen Thyristor.

Wenn das Schaltgerät 10 als Füllstandsgrenzschalter zur Überwachung eines maximalen Füllstands verwendet wird, soll das Relais 20 erregt werden, wenn der maximale Füllstand erreicht wird, und es soll wieder abfallen, wenn die Höhe des Füllguts im Behälter unter dem maximalen Füllstand liegt. Das Relais 20 soll also erregt sein, wenn das von der Signalverarbeitungsschaltung 16 abgegebene Signal S_{V} den Wert hat, der anzeigt, daß der Sensor 12 das Vorhandensein von Füllgut feststellt. Wenn dagegen das Schaltgerät 10 als Füllstandsgrenzschalter zur Überwachung eines minimalen Füllstandes verwendet wird, soll das Relais 20 erregt sein, wenn das von der Signalverarbeitungsschaltung 16 abgegebene Signal S_{V} den Wert hat, der anzeigt, daß der Sensor 12 kein Füllgut auf der zu überwachenden Höhe feststellt. Damit das gleiche Schaltgerät 10 ohne konstruktive Änderung für diese beiden unterschiedlichen Betriebsarten eingesetzt werden kann, soll es durch den Anwender am Einbauort umschaltbar sein. Die einzige Zugriffsmöglichkeit, die der Anwender auf das Schaltgerät hat, besteht über die Schaltgerätanschlüsse 10a, 10b, 10c. Das Schaltgerät 10 ist daher so ausgebildet, daß es durch unterschiedliches Anschließen der Spannungsquelle 18 und der Last 20 an die Schaltgerätanschlüsse 10a, 10b und 10c so programmierbar ist, daß es wahlweise in der einen oder in der anderen Betriebsart arbeitet.

Zu diesem Zweck enthält die Auswerteschaltung 14 einen steuerbaren Inverter 24, der an seinem Signaleingang das Ausgangssignal S_{V} der Signalverarbeitungsschaltung 16 empfängt und an seinem Ausgang das Schaltsignal S_{S} abgibt. Der steuerbare Inverter 24 hat ferner einen Steuereingang, der mit dem Ausgang eines Speichers 26 verbunden ist und von diesem Ausgang ein Steuersignal S_{C} empfängt, das bestimmt, ob der Inverter das Signal S_{V} direkt, also ohne Invertierung, als Schaltsignal S_{S} übertragen soll, oder ob er das Signal S_{V} invertieren soll, so daß das Schaltsignal S_{S} stets komplementär zu dem Signal S_{V} ist.

Der Schaltgerätanschluß 10a ist direkt mit dem einen Versorgungsspannungsanschluß 14b der Auswerteschaltung 14 verbunden, der im dargestellten Fall der Anschluß für den negativen Pol der Versorgungsspannung ist. Der zum Anschluß 14c führende Versorgungsspannungsleiter 28 für den positiven Pol der Versorgungsspannung ist über eine Diode 30 mit dem Schaltgerätanschluß 10b und über eine Diode 32 mit dem Schaltgerätanschluß 10c verbunden. Die Dioden 30 und 32 sind so gepolt, daß sie in der Richtung vom Schaltgerätanschluß 10b bzw. 10c zum Versorgungsspannungsleiter 28 durchlassen und in der Gegenrichtung sperren. Mit dem Versorgungsspannungsleiter 28 ist auch die eine Seite des Schalters 22 verbunden, dessen andere Seite über eine Diode 34 mit dem Schaltgerätanschluß 10b und über eine Diode 36 mit dem Schaltgerätanschluß 10c verbunden ist. Die Dioden 34 und 36 sind so gepolt, daß sie in der Richtung vom Schalter 22 zum Schaltgerätanschluß 10b bzw. 10c durchlassen und in der Gegenrichtung sperren. Zwischen den Schaltgerätanschlüssen 10b und 10a ist ein Spannungsteiler 40 angeschlossen, der aus einem Widerstand 42 in Reihe mit einer Zenerdiode 44 gebildet ist. Der Abgriff 46 des Spannungsteilers 40 ist über den Anschluß 14d der Auswerteschaltung 14 mit einem Eingang des Speichers 26 verbunden und liefert zu diesem Eingang das Umsteuersignal S_{U}. Ein weiterer Eingang des Speichers 26 empfängt das Schaltsignal S_{S} vom Ausgang des Inverters 24. Der Speicher 26 dient zur Speicherung einer binären Information, die durch die Signale S_{S} und S_{U} bestimmt wird und ihrerseits den Signalwert des Steuersignals S_{C} festlegt.

Fig. 1 zeigt die Beschaltung des Schaltgeräts 10 für den Fall, daß es zur Überwachung eines maximalen Füllstands verwendet wird, wobei angenommen wird, daß in diesem Fall keine Invertierung des Schaltsignals S_{S} im Inverter 24 stattfindet. Die Spannungsquelle 18 ist zwischen den Schaltgerätanschlüssen 10a und 10b angeschlossen, und die Last 20 ist zwischen den Schaltgerätanschlüssen 10a und 10c angeschlossen. Fig. 2 zeigt zum besseren Verständnis ein Ersatzschaltbild des Schaltgeräts 10 in dieser Beschaltung, wobei die in der Durchlaßrichtung beaufschlagten Dioden durch durchgehende Leiter dargestellt und die in der Sperrichtung beaufschlagten Dioden fortgelassen sind.

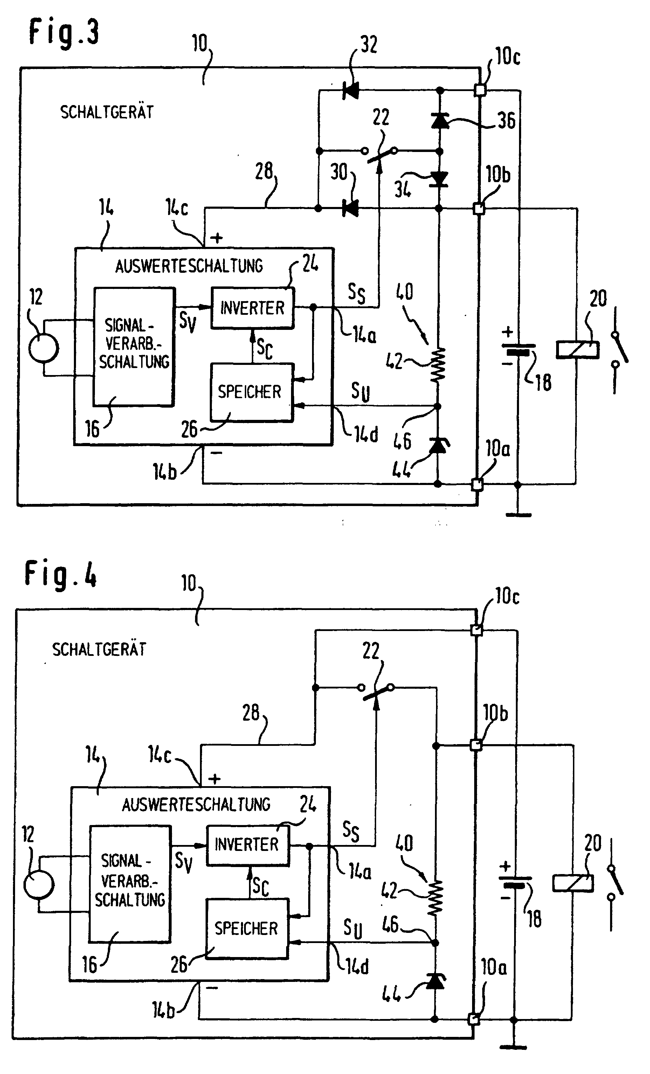

Fig. 3 zeigt die Beschaltung des Schaltgeräts 10 für den Fall, daß es zur Überwachung eines minimalen Füllstands verwendet wird, wozu das Schaltsignal S_{S} im Inverter 24 invertiert werden muß, und Fig. 4 zeigt das entsprechende Ersatzschaltbild. Gegenüber der Beschaltung von Fig. 1 und 2 besteht der Unterschied, daß die Spannungsquelle 18 zwischen den Schaltgerätanschlüssen 10a und 10c angeschlossen ist, während die Last 20 zwischen den Schaltgerätanschlüssen 10a und 10b angeschlossen ist. In beiden Fällen bleiben also die Spannungsquelle 18 und die Last 20 mit dem gemeinsamen Schaltgerätanschluß 10a verbunden, der zugleich an Masse liegt; die Umschaltung zwischen Maximalwertüberwachung und Minimalwertüberwachung erfolgt dadurch, daß die Verbindungen mit den beiden anderen Schaltgerätanschlüssen 10b und 10c vertauscht werden.

Wie insbesondere aus den Figuren 2 und 4 erkennbar ist, legt in beiden Fällen der Schalter 22 im geschlossenen Zustand die Spannung der Spannungsquelle 18 an die Last 20 an, während er im geöffneten Zustand den Stromkreis zur Last 20 unterbricht. Dagegen besteht ein Unterschied hinsichtlich der Erzeugung des Umschaltsignals S_{U}: Im Fall von Fig. 1 und 2 liegt die Spannung der Spannungsquelle 18 dauernd am Spannungsteiler 40 an, so daß das Umschaltsignal S_{U} immer einen vom Massepotential verschiedenen Spannungswert hat, unabhängig davon, ob der Schalter 22 offen oder geschlossen ist und welchen Wert das Schaltsignal S_{S} hat. Im Fall von Fig. 3 und 4 liegt dagegen die Spannung der Spannungsquelle 18 nur dann am Spannungsteiler 40 an, wenn der Schalter 22 geschlossen ist. Dieser Unterschied wird dazu ausgenutzt, die im Speicher 26 gespeicherte binäre Information so einzustellen, daß das zum Inverter 24 geschickte Steuersignal S_{C} jeweils den Signalwert hat, der bewirkt, daß das Signal S_{V} im Fall der Beschaltung gemäß Fig. 1 und 2 im Inverter 24 nicht invertiert wird, jedoch im Fall der Beschaltung von Fig. 3 und 4 invertiert wird.

Trifft man für die Signalwerte der Signale S_{S}, S_{U} und S_{C} die folgende Übereinkunft:
S_{S} = 0: Schalter 22 offen; S_{S} = 1: Schalter 22 geschlossen
S_{U} = 0: Massepotential; S_{U} = 1: anderes Potential
S_{C} = 0: Invertierung; S_{C} = 1: keine Invertierung
so erfolgt die Einstellung der im Speicher 26 gespeicherten binären Information und damit des Signals S_{C} nach der folgenden Zuordnungstabelle:

| | | | | |
|---|---|---|---|---|
| S_{S} | 0 | 1 | 0 | 1 |
| S_{U} | 0 | 0 | 1 | 1 |
| S_{C} | 0 | x | 1 | x |

Dabei bedeutet der Buchstabe x, daß die im Speicher 26 gespeicherte binäre Information nicht geändert wird. Eine Änderung der gespeicherten binären Information erfolgt also nur dann, wenn das Schaltsignal S_{S} den Wert 0 hat; der Speicher 26 wird dann so eingestellt, daß das Steuersignal S_{C} den gleichen Wert wie das Umsteuersignal S_{U} annimmt, wenn es diesen Wert nicht bereits hatte. Wenn das Schaltsignal S_{S} dagegen den Wert 1 hat, findet keine Änderung der im Speicher 26 gespeicherten binären Information statt, unabhängig von dem Wert des Umsteuersignals S_{U}.

Der Zustand, daß die Signale S_{S} und S_{U} beide den Wert 0 haben, tritt nur bei der Beschaltung gemäß Fig. 3 und 4 ein. Bei dieser Beschaltung wird daher die im Speicher 26 gespeicherte Information so eingestellt, daß das Signal S_{C} dauernd den Wert 0 hat und damit das Signal S_{V} stets invertiert wird. Dies entspricht der Überwachung des minimalen Füllstands. Der Speicher 26 behält diesen Zustand bei, bis die Beschaltung geändert wird, also in den Zustand von Fig. 1 und 2 gebracht wird. Dann hat das Umsteuersignal S_{U} dauernd den Signalwert 1, und die im Speicher 26 gespeicherte binäre Information wird so eingestellt, daß auch das Signal S_{C} den Wert 1 annimmt, der bewirkt, daß im steuerbaren Inverter 24 keine Invertierung des Signals S_{V} stattfindet.

Auf diese Weise kann das gleiche Schaltgerät 10 ohne konstruktive Änderung wahlweise zur Maximalwertüberwachung oder zur Minimalwertüberwachung verwendet werden, wobei die gewünschte Funktion jeweils am Einbauort durch die Art der Beschaltung der Schaltgerätanschlüsse 10b und 10c bestimmt wird.

Die Einstellung der das Steuersignal S_{C} bestimmenden binären Information im Speicher 26 erfolgt sowohl bei einer Vertauschung der Anschlüsse von Spannungsquelle und Last als auch bei jedem Einschalten des Geräts und nach jedem Stromausfall. In jedem dieser Fälle liegt für eine gewisse Zeit ein Spannungsausfall an der elektronischen Schaltung vor, der zur Folge hat, daß der Schalter 22 geöffnet wird. Beim Wiedereinschalten der Spannung besteht daher stets ein Zustand, der mit Sicherheit die Beschaltung der Schaltgerätanschlüsse erkennen läßt, so daß die richtige Einstellung des Steuersignals S_{C} gewährleistet ist.

Die Auswerteschaltung 14 und ihre Bestandteile können von jedem Fachmann aufgrund der vorstehenden Beschreibung ihrer Funktionsweise realisiert werden, ohne daß es hierfür näherer Erläuterungen bedarf. Wenn die Auswerteschaltung 14 aus diskreten Elektronik-Bauteilen aufgebaut wird, kann der steuerbare Inverter 24 beispielsweise durch eine Exklusiv-ODER-Schaltung (Antivalenzschaltung) gebildet sein, die bekanntlich die Eigenschaft hat, daß ein dem einen Eingang zugeführtes Binärsignal in Abhängigkeit von dem Binärwert des dem anderen Eingang zugeführten Binärsignals invertiert oder nicht invertiert wird. Der Speicher 26 kann in diesem Fall durch ein einstufiges Register, beispielsweise in Form eines Flipflops, gebildet sein. Der modernen Technik entsprechend kann die Auswerteschaltung 14 aber auch durch einen geeignet programmierten Mikroprozessor realisiert werden; in diesem Fall werden die Funktionen des steuerbaren Inverters 24 und des Speichers 26 durch entsprechende Programmierung realisiert.

Der Spannungsteiler 40 hat den Zweck, die Spannung der Spannungsquelle 18 auf den Wert herabzusetzen, den das Umschaltsignal S_{U} für die richtige Ansteuerung des Speichers 26 haben soll. Er kann daher entfallen, wenn die Spannung der Spannungsquelle diesem Wert entspricht; in diesem Fall kann das Umsteuersignal S_{U} unmittelbar am Schaltgerätanschluß 10b abgenommen werden.

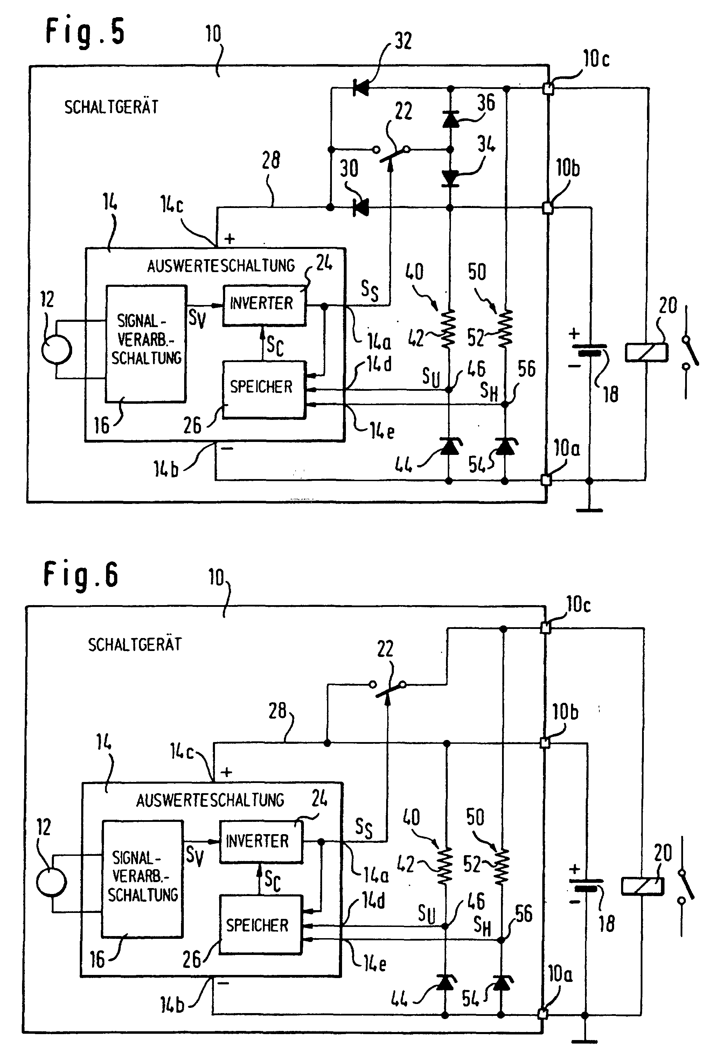

Die in den Figuren 5 bis 8 dargestellte zweite Ausführungsform der Erfindung unterscheidet sich von der in den Figuren 1 bis 4 dargestellten ersten Ausführungsform nur dadurch, daß ein zweiter Spannungsteiler 50 hinzugefügt ist, der zwischen den Schaltgerätanschlüssen 10c und 10a angeschlossen ist. Dieser zweite Spannungsteiler ist in gleicher Weise wie der erste Spannungsteiler 40 aus einem Widerstand 52 in Reihe mit einer Zenerdiode 54 gebildet. Der Abgriff 56 des Spannungsteilers 50 ist über einen weiteren Anschluß 14e der Auswerteschaltung 14 mit einem weiteren Eingang des Speichers 26 verbunden. Das am Abgriff 56 abgenommene und dem Speicher 26 zugeführte Signal wird als Hilfssignal S_{H} bezeichnet.

Die übrigen Bestandteile der zweiten Ausführungsform des elektronischen Schaltgeräts sind mit denjenigen der ersten Ausführungsform identisch und daher mit den gleichen Bezugszeichen bezeichnet; sie werden nicht nochmals erläutert. Ferner ist zu erkennen, daß sich die Darstellungen in den Figuren 5 bis 8 von denjenigen in den Figuren 1 bis 4 jeweils nur durch die Hinzufügung des Spannungsteilers 50 unterscheiden.

Der Spannungsteiler 50 dient zur zusätzlichen Kontrolle, um festzustellen, ob der Anwender das Schaltgerät durch einen Kurzschluß zwischen den Schaltgerätanschlüssen 10b und 10c überbrückt hat. In einem solchen Fall hätte das Umsteuersignal S_{U} auch dann, wenn das Schaltsignal S_{S} den Wert 0 hat und somit der Schalter 22 offen ist, stets den Wert 1, unabhängig von der Beschaltung der Schaltgerätanschlüsse 10b und 10c. In diesem Fall darf keine Einstellung der im Speicher 26 gespeicherten binären Information auf den Wert des Umsteuersignals S_{U} stattfinden.

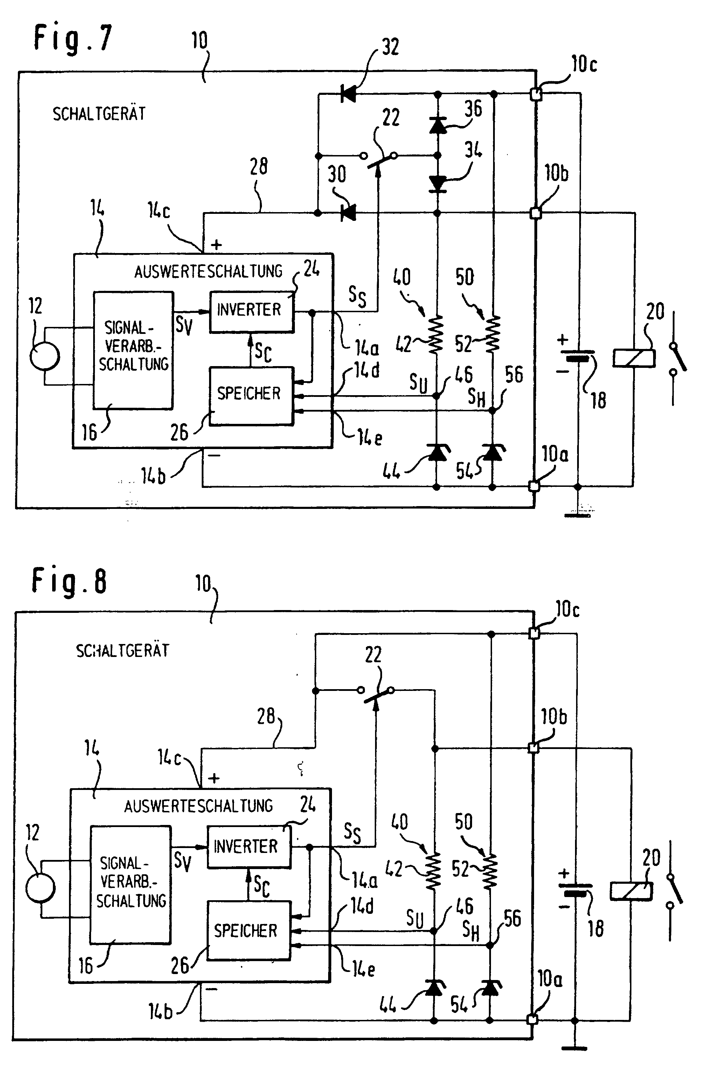

Das Hilfssignal S_{H} läßt diesen unzulässigen Zustand erkennen. Trifft man für die Signalwerte des Hilfssignals S_{U} die gleiche Übereinkunft wie für die Signalwerte des Umsteuersignals S_{U}, also:
S_{H} = 0: Massepotential; S_{H} = 1: anderes Potential,
so ist aus den Figuren 6 und 8 unmittelbar ersichtlich:

Wenn das Schaltsignal S_{S} den Wert 0 hat, können die Signale S_{U} und S_{H} nur dann gleichzeitig den Wert 1 haben, wenn
- entweder die Schaltgeräteanschlüsse 10b und 10c kurzgeschlossen sind
- oder der Schalter 22 defekt ist und nicht geöffnet hat.

Wenn somit in der Auswerteschaltung 14 festgestellt wird, daß die Signale S_{U} und S_{H} gleichzeitig den Wert 1 haben, während das Schaltsignal S_{S} den Wert 0 hat, wird die Einstellung der im Speicher 26 gespeicherten binären Information verhindert.

Da der Speicher 26 jetzt durch drei binäre Signale gesteuert wird, gibt es acht verschiedene Signalzustände gemäß der folgenden Tabelle:

| | a | b | c | d | e | f | g | h |
|---|---|---|---|---|---|---|---|---|
| S_{S} | 1 | 0 | 1 | 0 | 1 | 0 | 1 | 0 |
| S_{U} | 1 | 1 | 0 | 0 | 1 | 1 | 0 | 0 |
| S_{H} | 1 | 1 | 1 | 1 | 0 | 0 | 0 | 0 |
| S_{C} | x | x | x | 0 | x | 1 | - | - |

Hierbei bedeutet der Buchstabe x wieder, daß die im Speicher gespeicherte binäre Information nicht geändert wird.

Die Fälle g und h sind irrelevant, da sie bedeuten, daß keine Spannungsquelle angeschlossen ist.

Die Fälle c, d, e, f entsprechen den vier Fällen, die zuvor für das erste Ausführungsbeispiel angegeben worden sind. Das Hilfssignal S_{H} bleibt in diesen Fällen ohne Einfluß, da es stets den zum Umsteuersignal S_{U} entgegengesetzten Wert hat. Es erfolgt daher in den Fällen d und f, in denen das Schaltsignal S_{S} den Wert 0 hat, eine Einstellung der im Speicher 26 gespeicherten binären Information in der Weise, daß das Steuersignal S_{C} den gleichen Wert wie das Umsteuersignal S_{U} annimmt. Der Fall d besteht nur dann, wenn die Spannungsquelle zwischen den Schaltgerätanschlüssen 10a und 10c angeschlossen ist (Fig. 7 und 8), und der Fall f besteht nur dann, wenn die Spannungsquelle zwischen den Schaltgerätanschlüssen 10a und 10b angeschlossen ist (Fig. 5 und 6).

Der kritische Fall ist der Fall b: dieser Fall kann nur eintreten, wenn ein Kurzschluß zwischen den Schaltgerätanschlüssen 10b und 10c besteht oder der Schalter 22 defekt ist und nicht öffnet. In diesem Fall verhindert die Tatsache, daß die Signale S_{U} und S_{H} beide den gleichen Wert 1 haben, eine Änderung der im Speicher 26 gespeicherten binären Information.

Die Signale S_{U} und S_{H} haben auch im Fall a beide den Wert 1, doch ist dies ohne Bedeutung, da in diesem Fall eine Änderung der im Speicher 26 gespeicherten binären Information bereits dadurch verhindert wird, das das Schaltsignal S_{S} den Wert 1 hat.

## Patentansprüche

1. Elektronisches Schaltgerät zur Steuerung der Verbindung einer Last mit einer Spannungsquelle in Abhängigkeit von einer zu überwachenden physikalischen Größe, mit einem Sensor, der ein von der physikalischen Größe abhängiges Ausgangssignal liefert, einer mit dem Sensor verbundenen Signalverarbeitungsschaltung, die ein binäres Signal liefert, das den einen oder den anderen Signalwert in Abhängigkeit davon annimmt, ob der Wert der zu überwachenden physikalischen Größe über oder unter einem vorgegebenen Schwellenwert liegt, einem Schalter, der die Verbindung zwischen der Spannungsquelle und der Last steuert und durch ein vom Signalwert des Ausgangssignals der Signalverarbeitungsschaltung abhängiges binäres Schaltsignal geöffnet oder geschlossen wird, und mit einem steuerbaren Inverter, der in Abhängigkeit vom Signalwert eines binären Steuersignals das Ausgangssignal der Signalverarbeitungsschaltung entweder direkt für eine erste Betriebsart oder invertiert für eine zweite Betriebsart als Schaltsignal zu dem Schalter überträgt, wobei das Schaltgerät drei Schaltgerätanschlüsse für den Anschluß der Spannungsquelle und der Last hat und so ausgebildet ist, daß es durch unterschiedliches Anschließen der Spannungsquelle und der Last für den Betrieb in der ersten Betriebsart oder für den Betrieb in der zweiten Betriebsart einstellbar ist, und wobei die Spannungsquelle eine Gleichspannungsquelle ist, die auch die für den Betrieb des Schaltgeräts erforderliche Versorgungsspannung zu einem Versorgungsspannungsleiter im Schaltgerät liefert, **dadurch gekennzeichnet, daß** ein erster Anschluß der Spannungsquelle (18) und ein erster Anschluß der Last (20) mit einem gemeinsamen ersten Schaltgerätanschluß (10a) verbunden sind, daß der zweite und der dritte Schaltgerätanschluß (10b, 10c) jeweils über eine Diode (30, 32) mit dem Versorgungsspannungsleiter (28) im Schaltgerät (10) verbunden sind, daß die eine Seite des Schalters (22) mit dem Versorgungsspannungsleiter (28) und die andere Seite des Schalters (22) jeweils über eine Diode (34, 36) mit dem zweiten und dem dritten Schaltgerätanschluß (10b, 10c) verbunden ist, daß das Schaltgerät (10) einen Speicher (26) für eine binäre Information enthält, der an einem ersten Signaleingang das von dem steuerbaren Inverter (24) geliefert Schaltsignal (S_{S}) und an einem zweiten Signaleingang ein von der Spannung zwischen dem ersten und dem zweiten Schaltgerätanschluß (10a, 10b) abhängiges Umsteuersignal (S_{U}) empfängt und an seinem Ausgang das binäre Steuersignal (S_{C}) für den steuerbaren Inverter (24) liefert, dessen Signalwert von der im Speicher (26) gespeicherten binären Information abhängt, daß der Speicher (26) so ausgebildet ist, daß er eine durch den Wert des Umsteuersignals (S_{U}) bestimmte binäre Information speichert, wenn das Schaltsignal (S_{S}) den Signalwert hat, bei dem der Schalter (22) geöffnet ist, und die zuvor gespeicherte binäre Information beibehält, wenn das Schaltsignal (S_{S}) den Wert hat, bei dem der Schalter (22) geschlossen ist, und daß zur Einstellung einer der beiden Betriebsarten der zweite Anschluß der Spannungsquelle (18) mit dem zweiten Schaltgerätanschluß (10b) und der zweite Anschluß der Last (20) mit dem dritten Schaltgerätanschluß (10c) verbunden sind und zur Einstellung der anderen Betriebsart diese beiden Verbindungen vertauscht sind.

2. Schaltgerät nach Anspruch 1, **dadurch gekennzeichnet, daß** zwischen dem ersten und dem zweiten Schaltgerätanschluß (10a, 10b) ein Spannungsteiler (40) angeschlossen ist, an dessen Abgriff (46) das Umsteuersignal (S_{U}) abgenommen wird.

3. Schaltgerät nach Anspruch 1 oder 2, **dadurch gekennzeichnet, daß** der Speicher (26) an einem dritten Signaleingang ein von der Spannung zwischen dem ersten und dem dritten Schaltgerätanschluß (10a, 10c) abhängiges Hilfssignal (S_{H}) empfängt und daß die Speicherung bzw. Änderung der binären Information im Speicher (26) verhindert wird, wenn das Hilfssignal (S_{H}) den gleichen Signalwert wie das Umsteuersignal (S_{U}) hat.

4. Schaltgerät nach Anspruch 3, **dadurch gekennzeichnet, daß** zwischen dem ersten und dem dritten Schaltgerätanschluß (10a, 10c) ein Spannungsteiler (50) angeschlossen ist, an dessen Abgriff (56) das Hilfssignal (S_{H}) abgenommen wird.

5. Schaltgerät nach Anspruch 2 oder 4, **dadurch gekennzeichnet, daß** jeder Spannungsteiler (40, 50) durch die Reihenschaltung eines Widerstands (42, 52) und einer Zenerdiode (44, 54) gebildet ist.

6. Schaltgerät nach einem der vorhergehenden Ansprüche, **dadurch gekennzeichnet, daß** der gemeinsame erste Schaltgerätanschluß (10a) auf einem festen Bezugspotential liegt.

## Claims

1. Electronic switchgear for controlling the connection of a load to a voltage source as a function of a physical variable to be monitored, comprising a sensor which delivers an output signal dependent upon the physical variable, a signal processing circuit connected to the sensor and delivering a binary signal which assumes the one or the other signal value as a function of whether the value of the physical variable to be monitored lies above or below a predetermined threshold value, a switch which controls the connection between the voltage source and the load and which is opened or closed by a binary switching signal dependent upon the value of the output signal of the signal processing circuit, and a controllable inverter which, as a function of the signal value of a binary control signal, transmits the output signal of the signal proce ssing circuit as a switching signal to the switch either directly for a first operating mode or in inverted form for a second operating mode, wherein the switchgear has three switchgear terminals for the connection of the voltage source and the load and is formed so that, by differently connecting the voltage source and the load, it can be set for operation in the first operating mode or for operation in the second operating mode, and wherein the voltage source is a direct-current voltage source which also delivers the supply voltage, necessary for operation of the switchgear, to a supply-voltage conductor in the switchgear, **characterised in that** a first terminal of the voltage source (18) and a first terminal of the load (20) are connected to a common first switchgear terminal (10a), **in that** the second and the third switchgear terminal (10b, 10c) are connected to the supply-voltage conductor (28) in the switchgear (10) via a respective diode (30, 32), **in that** one side of the switch (22) is connected to the supply-voltage conductor (28) and the other side of the switch (22) is connected to the second and the third switchgear terminal (10b, 10c) via a respective diode (34, 36), **in that** the switchgear (10) contains a memory (26) for a binary datum, the memory (26) receiving, at a first signal input, the switching signal (S_{S}) delivered by the controllable inverter (24) and, at a second signal input, a reversing signal (S_{U}) dependent upon the voltage between the first and the second switchgear terminal (10a, 10b) and, at its output, delivering the binary control signal (S_{C}) for the controllable inverter (24), the signal value of which is dependent upon the binary datum stored in the memory (26), **in that** the memory (26) is formed so that it stores a binary datum, determined by the value of the reversing signal (S_{U}), if the switching signal (S_{S}) has the signal value at which the switch (22) is open, and retains the previously stored binary datum if the switching signal (S_{S}) has the value at which the switch (22) is closed, and **in that**, to set one of the two operating modes, the second terminal of the voltage source (18) is connected to the second switchgear terminal (10b), and the second terminal of the load (20) is connected to the third switchgear terminal (10c), and to set the other operating mode these two connections are interchanged.

2. Switchgear according to claim 1, **characterised in that** between the first and the second switchgear terminal (10a, 10b) is connected a voltage divider (40), at the tap point (46) of which the reversing signal (S_{U}) is picked up.

3. Switchgear according to claim 1 or 2, **characterised in that** the memory (26) receives, at a third signal input, an auxiliary signal (S_{H}) dependent upon the voltage between the first and the third switchgear terminal (10a, 10c), and **in that** storage or modification of the binary datum in the memory (26) is prevented if the auxiliary signal (S_{H}) has the same signal value as the reversing signal (S_{U}).

4. Switchgear according to claim 3, **characterised in that** between the first and the third switchgear terminal (10a, 10c) is connected a voltage divider (50), at the tap point (56) of which the auxiliary signal (S_{H}) is picked up.

5. Switchgear according to claim 2 or 4, **characterised in that** each voltage divider (40, 50) is formed by the series connection of a resistor (42, 52) and a Zener diode (44, 54).

6. Switchgear according to any one of the preceding claims, **characterised in that** the common first switchgear terminal (10a) lies on a fixed reference potential.

## Revendications

1. Appareil de connexion électronique pour commander une liaison d'une charge avec une source de tension en fonction d'une grandeur physique à surveiller, doté d'un capteur qui fournit un signal de sortie en fonction de la grandeur physique, d'un circuit de traitement de signal relié au capteur qui fournit un signal binaire qui représente l'une ou l'autre valeur de signal si la valeur de la grandeur physique à surveiller se situe au dessus ou en dessous une valeur seuil prédéterminée, un commutateur qui commande la liaison entre la source de tension et la charge et qui est ouvert ou fermé par un signal de commutation binaire selon de la valeur de signal du signal de sortie du circuit de traitement de signal, et doté d'un inverseur susceptible d'être commandé qui, selon la valeur de signal d'un signal de commande binaire, transmet le signal de sortie du circuit de traitement de signal soit directement pour un premier type de fonctionnement ou de façon inversée pour un second type de fonctionnement ; l'appareil de connexion ayant trois raccords d'appareil de connexion pour le raccordement de la source de tension et de la charge et est formé de manière à pouvoir être réglé par différents raccords de la source de tension et de la charge pour fonctionner selon le premier type de fonctionnement ou pour fonctionner selon le second type de fonctionnement, et où la source de tension est une source de tension continue qui fournit également pour le fonctionnement de l'appareil de connexion, la tension d'alimentation nécessaire pour un conducteur d'alimentation de tension dans l'appareil de connexion, **caractérisé en ce qu'**un premier raccord de la source de tension (18) et un premier raccord de la charge (20) sont reliés avec un premier raccord d'appareil de connexion (10a) commun, que le second et le troisième raccord d'appareil de connexion (10b, 10c) sont reliés à chaque fois par une diode (30, 32) avec la conduite d'alimentation de tension (28) dans l'appareil de connexion (10), qu'un côté du circuit (22) est relié à chaque fois par une diode (34, 36) avec le second et le troisième raccord d'appareil de connexion (10b, 10c), que l'appareil de connexion (10) comprend une mémoire (26) pour une information binaire, qui reçoit de l'inverseur (24) susceptible d'être commandé un signal de commutation (S_{S}) et à la seconde entrée de signal, un signal de déviation (SU) dépendant de la tension entre le premier et le second raccord d'appareil de connexion (10a, 10b) et fournit à sa sortie, le signal de commande (SC) binaire pour l'inverseur (24) susceptible d'être commandé ; la valeur de signal pour ledit inverseur dépendant de l'information binaire stockée dans la mémoire (26), **caractérisé en ce que** la mémoire (26) est formée de manière à ce qu'elle stocke une information binaire déterminée par la valeur du signal de déviation (SU) lorsque le signal de commutation (S_{S}) a la valeur de signal, à laquelle le commutateur (22) s'ouvre et détienne l'information binaire stockée auparavant, lorsque le signal de commutation (S_{S}) a la valeur à laquelle le commutateur (22) se ferme et **caractérisé en ce que** pour régler un des deux types de fonctionnement, le second raccord de la source de tension (18) est relié avec le second raccord d'appareil de connexion (10b) et le second raccord de la charge (20) est relié avec le troisième raccord d'appareil de connexion (10c) et que pour le réglage des autres types de fonctionnement, les deux liaisons sont échangées.

2. Appareil de connexion selon la revendication 1, **caractérisé en ce qu'**entre le premier et le second raccord d'appareil de connexion (10a, 10b), on a raccordé un réducteur (40) à la prise dudit réducteur (46) on capte le signal de déviation (S_{U}).

3. Appareil de connexion selon la revendication 1 ou 2, **caractérisé en ce que** la mémoire (26) reçoit sur une troisième entrée de signal, un signal d'aide (S_{H}) dépendant de la tension entre le premier et le troisième raccord d'appareil de connexion (10a, 10c) et **en ce qu'**on empêche le stockage, respectivement le changement de l'information binaire dans la mémoire (26) lorsque le signal d'aide (S_{H}) a la même valeur de signal que le signal de déviation (S_{U}).

4. Appareil de connexion selon la revendication 3, **caractérisé en ce qu'**on a raccordé un réducteur (50) entre le premier et le troisième raccord d'appareil de connexion (10a, 10c), sur la prise dudit réducteur (56) on capte le signal d'aide (S_{H}).

5. Appareil de connexion selon la revendication 2 ou 4, **caractérisé en ce que** chaque réducteur (40, 50) est formé par le circuit en série d'une résistance (42, 52) et une diode Zener (44, 54).

6. Appareil de connexion selon une des revendications précédentes, **caractérisé en ce que** le premier raccord d'appareil de connexion (10a) commun se trouve sur un potentiel de référence fixe.
